# EUROPEAN PATENT SPECIFICATION

(11) **EP 2 197 074 B1**
(45) Date of publication and mention of the grant of the patent: **12.12.2012**
(21) Application number: 08777048.3
(22) Date of filing: 30.05.2008
(51) Int. Cl.: G02F 1/1368, H01Q 1/38, G06K 19/00, H01L 27/13, H01P 11/00, H01Q 1/24, H01Q 7/00, H04M 1/02, H01Q 1/36, H05K 1/00, H01Q 1/22

(54) **ANTENNA DEVICE, DISPLAY DEVICE SUBSTRATE, LIQUID CRYSTAL DISPLAY UNIT, DISPLAY SYSTEM, METHOD FOR MANUFACTURING ANTENNA DEVICE AND METHOD FOR MANUFACTURING DISPLAY DEVICE SUBSTRATE**
ANTENNENVORRICHTUNG, SUBSTRAT FÜR EINE ANZEIGEVORRICHTUNG, FLÜSSIGKRISTALLANZEIGEEINHEIT, ANZEIGESYSTEM, VERFAHREN ZUR HERSTELLUNG EINER ANTENNENVORRICHTUNG UND VERFAHREN ZUR HERSTELLUNG EINES SUBSTRATS FÜR EINE ANZEIGEVORRICHTUNG
DISPOSITIF D'ANTENNE, SUBSTRAT DE DISPOSITIF D'AFFICHAGE, UNITÉ D'AFFICHAGE À CRISTAUX LIQUIDES, SYSTÈME D'AFFICHAGE, PROCÉDÉ DE FABRICATION D'UN DISPOSITIF D'ANTENNE ET PROCÉDÉ DE FABRICATION D'UN SUBSTRAT DE DISPOSITIF D'AFFICHAGE

(30) Priority: 27.09.2007 JP 2007252702
(43) Date of publication of application: 16.06.2010
(73) Proprietor: Sharp Kabushiki Kaisha, Osaka-shi, Osaka 545-8522 (JP)
(72) Inventor: MIYATA, Kazuhiko, Osaka-shi Osaka 545-8522 (JP); LUKAMA, Lloyd, Oxford, OX4 4GB (GB); ZYAMBO, Emmanuel, Oxford OX4 1SH (GB); SHAH, Sunay, Oxford, OX4 4GB (GB)
(74) Representative: Müller - Hoffmann & Partner
(86) International application number: PCT/JP2008/060037
(87) International publication number: WO 2009/041119

(56) References cited:
- EP-A2- 1 547 719
- JP-A- 7 046 515
- JP-A- 2000 113 144
- JP-A- 2007 214 545
- JP-A- 2007 251 149
- JP-T- 2003 513 492
- US-A1- 2002 152 606
- US-A1- 2007 195 834
- US-A1- 2007 197 049

## Description

### Technical Field

The present invention relates to a display device substrate comprising an device, a liquid crystal display unit using the antenna device, and a display system using the antenna device. The present invention also relates to method for manufacturing the display device substrate.

### Background Art

Conventionally, there has been proposed a method for downsizing an antenna for use in a small portable device provided with a display section realized by an LCD (Liquid Crystal Display). According to the method, the antenna is realized with use of (i) an LCD reflective plate or (ii) electrodes between which a liquid crystal material is sandwiched (see Patent Literature 1). There has been proposed an alternative method for downsizing an antenna. According to the method, the antenna is realized with use of a data signal line and a scanning signal line of LCD (see Patent Literature 2). That is, conventionally, an effort for downsizing an antenna has been made under a concept in which an existing configuration having a certain function in the device is used also as an antenna.

In a case where an antenna and electric wiring are formed monolithically through a thin film process, the antenna and the electric wiring have been conventionally made of the same material through a single process. In this case, it is impossible to freely choose a material of which the antenna is made. Therefore, in order to achieve a performance which an antenna should have, it is necessary to suitably design the size of the antenna. Thus, it is sometimes necessary that an antenna has a relatively large size because of the performance which the antenna should have. This causes a problem that the device cannot be downsized as a whole.

Further, according to conventional methods, an antenna intends to receive information. Therefore, it is difficult to achieve a display device which (i) transmits all electric power required for driving to continue displaying an LCD and the like and for driving accessories minimally required for maintaining display function (e.g., in a case of a transmissive LCD, a backlight LED in addition to the LCD) and (ii) requires no wiring connecting with its mother device is used.

US 2007/0195834 A1 discloses a laser irradiation apparatus and a method of laser irradiation which can improve use efficiency of a laser beam, eliminate an influence of stray light at a DMD, and form an irradiation pattern with a homogeneous beam spot. The laser irradiation apparatus includes at least a laser oscillator, a diffractive optical element, and an optical element having many minute mirrors arranged two-dimensionally.

US 2007/0197049 A1 discloses a method for manufacturing a semiconductor device wherein a desired position is rapidly subjected to laser irradiation while switching laser irradiation patterns. With respect to an organic memory element having a structure in which an organic compound layer is interposed between a pair of conductive layers, data is written to the organic memory element by laser irradiation using a laser irradiation apparatus.

### Citation List

Patent Literature 1
   Japanese Patent Application Publication, Tokukaisho, No. 64-73918 A (Publication Date: March 20, 1989)
Patent Literature 2
   Japanese Patent Application Publication, Tokukaihei, No. 7-46515 A (Publication Date: February 14, 1995)

### Summary of Invention

An object of the present invention is to provide a display device substrate comprising a An object of the present invention is to provide a high-performance antenna device which allows the device to be downsized as a whole and which can transmit electric power, in a case where an antenna and electric wiring are formed monolithically through a thin film process. Further, an object of the present invention is to provide a liquid crystal display unit using the antenna device, a display system using the antenna device, and a method for manufacturing the display device substrate.

In order to attain the foregoing objects a display device substrate according to claim 18 are provided.

According to these configuration and method, in the antenna device according to the present invention, the antenna and the electric wiring are monolithically formed on the substrate through a thin film process, and the antenna is made of the material having a higher electric conductivity than that of the material of which the electric wiring is made.

Generally, in the case where the antenna and the electric wiring are formed monolithically through a thin film process, the antenna and the electric wiring are made of the same material through one process. On the other hand, the present invention deliberately uses different materials for the antenna and the electric wiring, and sets an electric conductivity of the antenna to be higher than that of the electric wiring, so as to downsize the antenna.

Further, in the case where different materials are used for the antenna and the electric wiring, it is possible to select a suitable material for each of the antenna and the electric wiring, so that the advantages thereof are not reduced. For example, the electric wiring is generally made of an aluminum alloy, which has the advantages of e.g., ease of processing and low cost. However, the aluminum alloy is not suitable for a material of which the antenna is made. In view of this, with the present invention, the antenna is made of a material which is not the aluminum alloy, while the aluminum alloy is used for the electric wiring as in general. With this, it is possible to configure the antenna suitably, and to achieve the foregoing advantages.

Thus, in the case where an antenna and electric wiring are formed monolithically through a thin film process, it is possible to provide an antenna device with which the device is downsized as a whole.

In order to achieve the foregoing objects, a display device substrate of the present invention includes: the antenna device, a display circuit, which drives a plurality of pixels, being formed on the substrate as the electric circuit, and the antenna being provided in a region outside a display region where the plurality of pixels are provided.

Further, in order to achieve the foregoing objects, a method for manufacturing a display device substrate of the present invention is a method for manufacturing a display device substrate which includes an antenna device manufactured by the method for manufacturing an antenna device, wherein: a display circuit which drives a plurality of pixels is formed on the substrate as the electric circuit; and the antenna is provided in a region outside a display region where the plurality of pixels are provided.

With these configuration and method, since the size of the antenna can be reduced, it is possible to reduce, in the display device substrate, an area of the region which is outside the display region and in which the antenna is provided. Thus, it is possible to downsize the display device as a whole.

Further, it is possible to provide a liquid crystal display unit, including the display device substrate according to the present invention, said liquid crystal display unit carrying out a display by applying a voltage to liquid crystal.

Furthermore, it is possible to provide a display system including: a transmitting device for transmitting, by wireless, one of or both of a signal and electric power each of which is used by a display circuit in a receiving device to carry out a target display; and the receiving device including the display device substrate according to the present invention.

### Brief Description of Drawings

Fig. 1

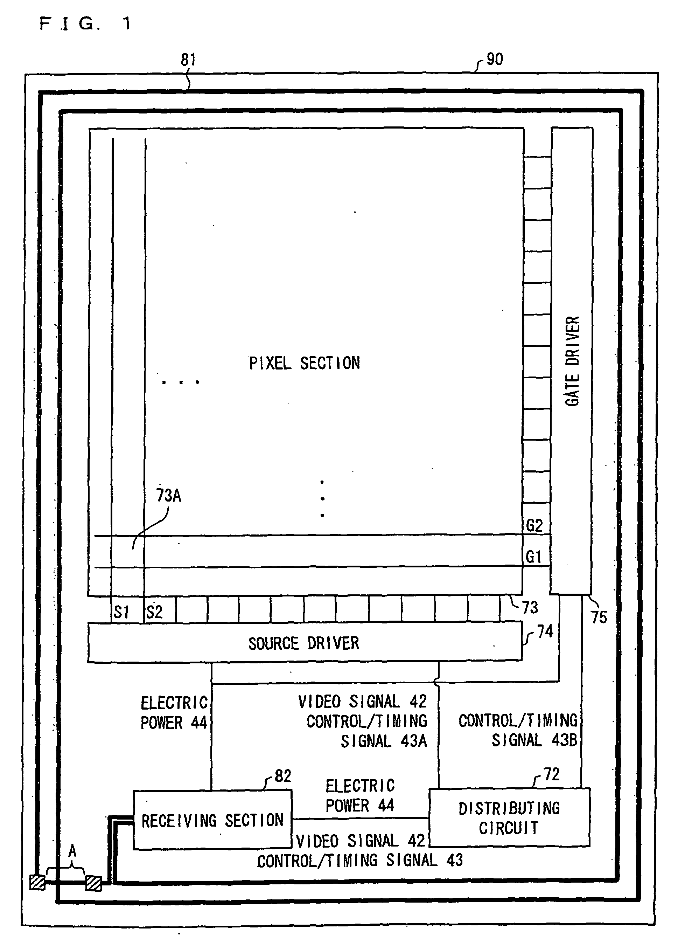

   Fig. 1, related to an embodiment of the present invention, is a view illustrating the configuration of a wireless display device.
Fig. 2

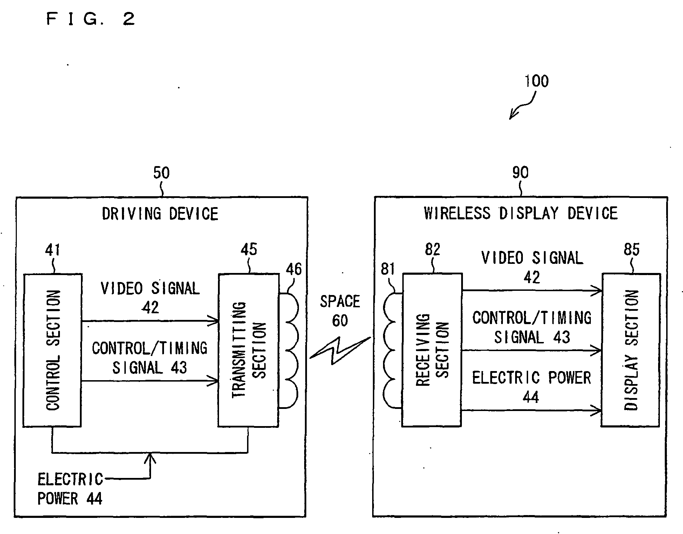

   Fig. 2, related to the embodiment of the present invention, is a view illustrating the configuration of a display system.
Fig. 3

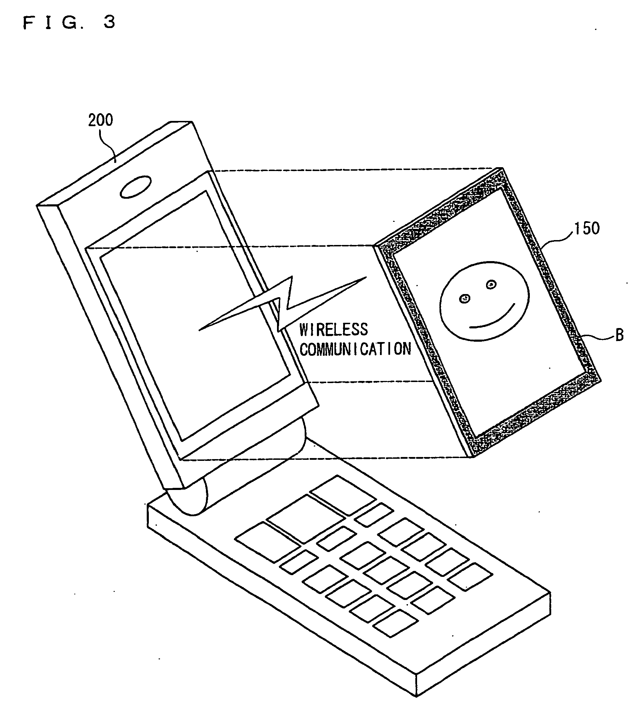

   Fig. 3 is a view illustrating an embodiment of the display system.
Fig. 4

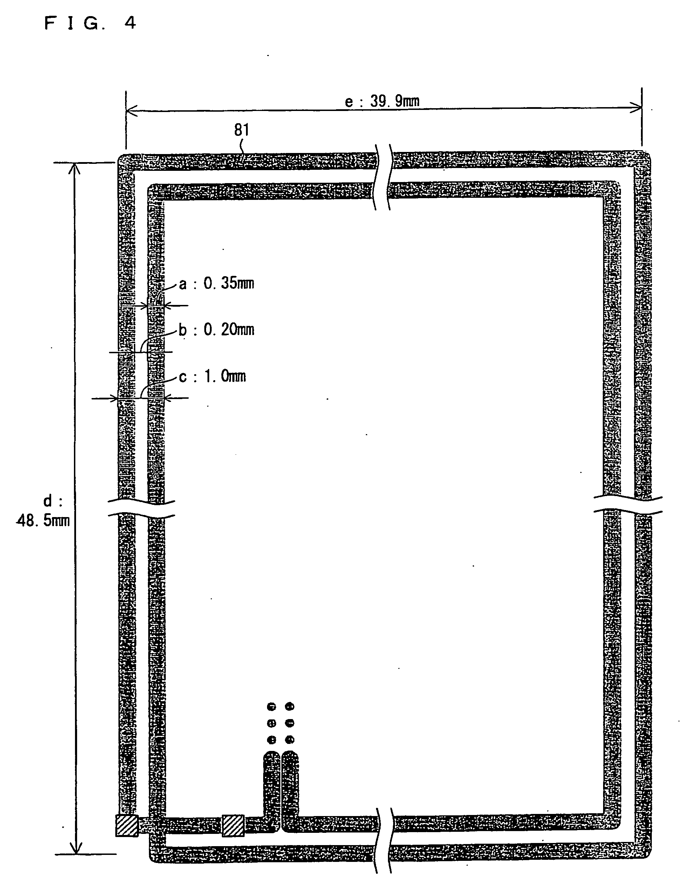

   Fig. 4, related to an embodiment of the present invention, is a view illustrating the configuration of an antenna.
Fig. 5

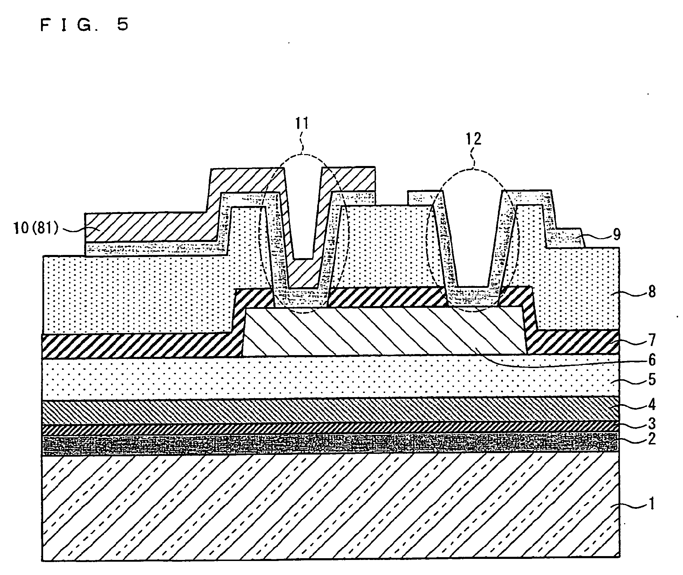

   Fig. 5, related to an embodiment of the present invention, is a cross-section view illustrating the configuration of an active matrix substrate.
Fig. 6

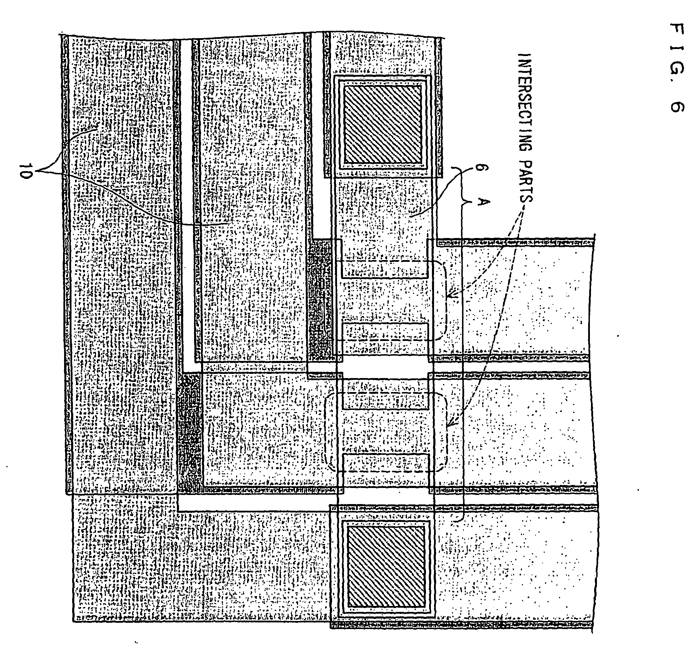

   Fig. 6, related to an embodiment of the present invention, is a plane view illustrating a part where an antenna and an underpass layer intersect with each other.
Fig. 7 (a)

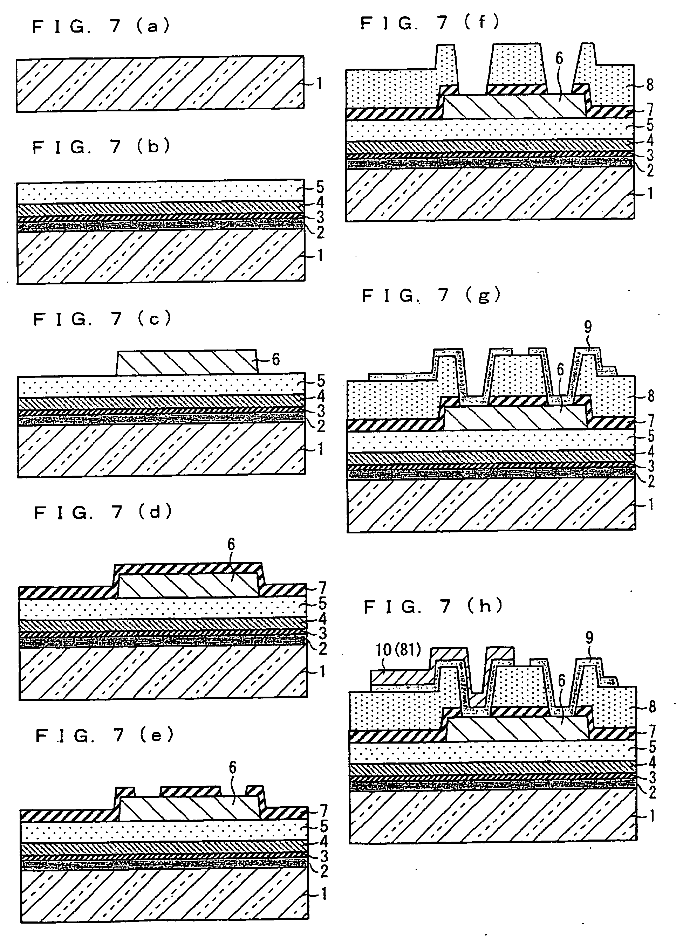

   Fig. 7 (a), related to an embodiment of the present invention, is a view illustrating a manufacturing process of the active matrix substrate.
Fig. 7 (b)
   Fig. 7 (b), related to the embodiment of the present invention, is a view illustrating the manufacturing process of the active matrix substrate.
Fig. 7 (c)
   Fig. 7 (c), related to the embodiment of the present invention, is a view illustrating the manufacturing process of the active matrix substrate.
Fig. 7 (d)
   Fig. 7 (d), related to the embodiment of the present invention, is a view illustrating the manufacturing process of the active matrix substrate.
Fig. 7 (e)
   Fig. 7 (e), related to the embodiment of the present invention, is a view illustrating the manufacturing process of the active matrix substrate.
Fig. 7 (f)
   Fig. 7 (f), related to the embodiment of the present invention, is a view illustrating the manufacturing process of the active matrix substrate.
Fig. 7 (g)
   Fig. 7 (g), related to the embodiment of the present invention, is a view illustrating the manufacturing process of the active matrix substrate.
Fig. 7 (h)
   Fig. 7 (h), related to the embodiment of the present invention, is a view illustrating the manufacturing process of the active matrix substrate.

### Reference Signs List

- 10, 81: Antenna
- 6: Underpass layer (electric wiring)
- 8: Interlayer insulating film
- 9: Transparent conductive film (ITO film)
- 85: Display section (electric circuit, display circuit)
- 50: Driving device (transmitting device)
- 90: Wireless display device (receiving device, liquid crystal display unit)
- 100: Display system
- B: Frame

### Description of Embodiments

One embodiment of the present invention is described below with reference to Fig. 1 through Fig. 7.

### (Configuration of Display System)

Fig. 2 illustrates the configuration of a display system 100 according to the present embodiment. As shown in Fig. 2, the display system 100 includes a driving device (transmitting device) 50 and a wireless display device (receiving device, liquid crystal display unit) 90. With the configuration, the driving device 50 transmits signals such as a video signal and a control/timing signal to the wireless display device 90 by wireless. Further, the driving device 50 supplies electric power to the wireless display device 90 by wireless power transmission of electromagnetic induction type or by wireless power transmission of resonance type. The wireless power transmission of resonance type refers to a technique in which a transmitting antenna and a receiving antenna are set to have an identical resonant frequency and the electric power is transmitted by use of a resonance phenomenon occurring between the two antennas. That is, only a receiving antenna having the same resonant frequency as that of a transmitting antenna is tuned to an electromagnetic wave transmitted via the transmitting antenna. This allows the receiving antenna to receive the electric power. The wireless display device 90 carries out a display operation in accordance with the signals transmitted from the driving device 50, with the use of the electric power thus transmitted by wireless power transmission.

The driving device 50 includes at least a control section 41, a transmitting section 45, and a transmitting antenna 46. The control section 41 outputs a video signal 42 and a control/timing signal 43 each of which is used by the wireless display device 90 to carry out a display. The transmitting section 45 encodes and modulates the video signal 42 and the control/timing signal 43, each supplied from the control section 41, and then transmits, via the transmitting antenna 46, an electromagnetic wave to a space 60. The control section 41 supplies the transmitting section 45 with electric power 44, so as to cause a wireless power transmission of an electromagnetic wave for supplying electric power via the transmitting antenna 46. This allows the video signal 42, the control/timing signal 43, and the electric power 44 to be transmitted to the wireless display device 90. Note that a signal encoding method, the configuration of a channel, and transmission system such as one-to-one, multiplexing, serial, or parallel are not limited to any particular ones.

The wireless display device 90 includes at least a receiving antenna 81, a receiving section 82, and a display section (electric circuit, display circuit) 85. The receiving section 82 receives the video signal 42, the control/timing signal 43, and the electric power 44 from the electromagnetic wave, which is transmitted by the driving device 50 and received via the receiving antenna 81, and then supplies these signals and electric power to the display section 85. Note that the electric power 44 is received by wireless power transmission. The display section 85 carries out a target display by using the signals and electric power supplied from the receiving section 82.

The present invention is directed to the receiving antenna (hereinafter, simply referred to as "antenna") 81 provided in the above-described wireless display device 90. The following explains the antenna of the present invention. For convenience of explanation, the display section 85 herein is assumed to be realized by a liquid crystal display (hereinafter, abbreviated as "LCD"). However, the present embodiment is not limited to this, and therefore the display section 85 can be any display device. Examples of such a display device encompass an organic EL (electroluminescence) display device.

### (Configuration of Wireless Display Device)

Fig. 1 shows a more detailed configuration of the wireless display device 90.

The receiving section 82 demodulates and decodes the electromagnetic wave supplied via the receiving antenna 81 so as to receive the video signal 42 and the control/timing signal 43, and also receives the electric power 44 by use of electromagnetic induction or resonance caused by the receiving antenna 81. The electric power 44 is used as electric power for the wireless display device 90.

The display section 85 includes at least a distributing circuit 72, a pixel section 73, a source driver 74, and a gate driver 75. The display device 85 has a general panel structure of an LCD. Briefly, the pixel section 73 includes an active matrix substrate (substrate, display device substrate, TFT array substrate), a color filter substrate on which a counter electrode is formed, a liquid crystal layer sandwiched between the active matrix substrate and the color filter substrate, a polarizing plate, and a backlight, for example.

The active matrix substrate includes: a plurality of data signal lines S (in Fig. 1, only data signal lines S1 and S2 are illustrated); a plurality of scanning signal lines G (in Fig. 1, only scanning signal lines G1 and G2 are illustrated) intersecting the data signal lines S; and a pixel provided in a region surrounded by any two adjacent data signal lines S and any two adjacent scanning signal lines G (in Fig. 1, only a pixel 73A, provided in a portion surrounded by the data signal lines S1 and S2 and the scanning signal lines G1 and G2, is illustrated). The pixel is constituted by members such as (i) a TFT (Thin Film Transistor) (not illustrated) which is connected with a data signal line S and a corresponding scanning signal line G and serves as a switching element and (ii) a pixel electrode (not illustrated). In the TFT, a gate is connected with the scanning signal line G, a source is connected with the data signal lien S, and a drain is connected with the pixel electrode. The pixel section (display region) 73 is a region in which the pixels are arranged in a matrix, and a voltage is actually applied to the liquid crystal layer so that a display is carried out.

Of the video signal 42 and the control/timing signal 43 supplied from the receiving section 82, the distributing circuit 72 outputs to the source driver 74 the video signal 42 and a control/timing signal 43A which is used to control the source driver 74, and outputs to the gate driver 75 a control/timing signal 43B which is used to control the gate driver 75.

In accordance with the video signal 42 and the control/timing signal 43A supplied from the distributing circuit 72, the source driver 74 outputs data signals to the respective data signal lines S. In accordance with the control/timing signal 43B supplied from the distributing circuit 72, the gate driver 75 applies gate voltages to the scanning signal lines G so as to drive the TFTs. This causes the voltages of the data signals to be applied to the liquid crystal layer as needed via the respective pixel electrodes, so that a target display is carried out. Examples of the control/timing signal 43 encompass a start pulse signal indicative of a position at which a display starts and a latch strobe signal (control/timing signal 43A) for latching the data signals at once in the source driver 73. In a case where the video signal 42 is digital, the control/timing signal 43 is a data clock, for example.

Note here that the antenna 81, the electric wiring connecting the antenna 81 with the receiving section 82, electric circuits constituting the receiving section 82, the distributing circuit 72, and each configuration formed on the active matrix substrate are monolithically formed through a thin film process. The thin film process refers to a series of steps in which a thin film is formed on a substrate by e.g., sputtering, and the thin film thus formed is processed, by use of photolithography as needed, so as to have a desired pattern. Note also that it is not necessary to form all of the configurations monolithically, provided that at least the antenna 81 and the electric wiring connecting the antenna 81 with the receiving section 82 are monolithically formed.

As illustrated in Fig. 1, the antenna 81 is provided (i) so as to extend around in an outermost region of the active matrix substrate and (ii) so as to surround the pixel section 73, the receiving section 82, the distributing circuit 72, and their connecting wiring. The antenna 81 only needs to be provided in a region outside a display region defined by the pixel section 73. Therefore, the member(s) such as the receiving section 82 and/or the distributing circuit 72 can be provided outside the region where the antenna 81 extends around in the outermost region of the active matrix substrate.

### (Conditions of Antenna)

As described above, in the case where the electric wiring connecting the antenna 81 with the receiving section 82 is formed monolithically, the antenna 81 is generally formed, through a single process, by use of the same material as that of the electric wiring. An aluminum alloy is in wide use as the material of the electric wiring. The aluminum alloy has a layer configuration in which an aluminum alloy, including aluminum as a main component, is sandwiched between metals having a high heat durability. The aluminum alloy wire having such a layer configuration or the like has an electric conductivity of 1.00 × 10⁷ (S/m) to 2.50 × 10⁷ (S/m).

As described above, the electric power 44 transmitted via the antenna 81 is used as electric power for the wireless display device 90, and therefore the electric power needs to be relatively large. In this regard, since the aluminum alloy wire has the above-mentioned electric conductivity, the antenna 81 made of the aluminum alloy wire needs to be designed so that (i) the number of turns of the antenna 81 is increased to some extent for the purpose of securing a necessary electric power and (ii) a diameter of the antenna 81 is increased for the purpose of decreasing a resistance of the antenna 81, for example. However, in the case where the number of turns of the antenna 81 is increased and/or the diameter of the antenna 81 is increased, the size of the antenna 81 is increased, and accordingly the display system 100 cannot be particularly applied to a small portable device.

Fig. 3 shows one example where the display system 100 is applied to a mobile phone 200, which serves as the small portable device. The driving device 50 is provided in the mobile phone 200. The wireless display device 90 is applied to an LCD module 150, which is attachable to and detachable from the mobile phone 200 and has a panel size of 2-inch class. In this case, the antenna 81 is provided in a frame part (i.e., a cover part), which is provided outside a display region (see "B" in Fig. 3) of the LCD module 150. The frame part has, at most, a width of approximately 1 (mm) to 2 (mm), and therefore the antenna 81 is forced to be downsized. In other words, in the LCD module 150, it is impossible to use the aluminum alloy wire as the material of the antenna 81.

Further, the antenna 81 deals with a large electric power (large electric current) as described above. Therefore, if the aluminum alloy wire having the foregoing electric conductivity is used as the antenna 81, a problem of heat generation is inevitable.

In order to address the problem, according to the present invention, the material of which the antenna 81 is made is different from the material of which the electric wiring is made. Specifically, the material of which the antenna 81 is made has a higher electric conductivity than that of the material of which the electric wiring is made (a specific value will be described later). This solves all of the problems, that is, a problem of securing of electric power, a problem of downsizing, and a problem of heat generation. Note that the electric wiring adopts the aluminum alloy wire as usual, although the use of the aluminum alloy wire increases the number of steps in manufacturing process. With this, it is possible to obtain at least the following beneficial effects brought by aluminum: excellent adhesion, ease of processing, low cost, and a low environmental burden. Note that the present invention also improves the steps of the manufacturing process so as to overcome the disadvantage of increasing the number of the steps in the manufacturing process (described in detail later).

### (Embodiment of Antenna)

Next, an embodiment of the antenna 81 will be described.

The present embodiment uses, as the material of which the antenna 81 is made, a material having an electric conductivity of 3.80 × 10⁷ or more, specifically, any one of silver (may be a silver alloy including silver as a main component), copper (may be a copper alloy including copper as a main component), and gold (may be a gold alloy including gold as a main component). The following describes the reason for this. Table 1 shows the electric conductivities of the above-mentioned respective metals. Note that a material of real wiring of an LCD in Table 1 corresponds to the above-mentioned aluminum alloy wiring.

**[Table 1]**

| Metal | Electric conductivity (S/m) |
|---|---|
| Pure silver (Ag) | 6.29 × 10⁷ |
| Pure copper (Cu) | 5.99 × 10⁷ |
| Pure gold (Au) | 4.25 × 10⁷ |
| Pure aluminum (A1) | 3.76 × 10⁷ |
| Material of real wiring of LCD (A1 alloy + surface protecting metal) | 1.00 × 10⁷ to 2.50 × 10⁷ |

In order to drive general TN (Twisted Nematic) liquid crystal, it is necessary to apply a driving voltage of over ten volts to the general TN liquid crystal. That is, it is preferable that a power supply voltage supplied to the wireless display device 90 via the antenna 81 is 20 V or more, in consideration of (i) a voltage drop of a regulator which supplies a necessary voltage to a circuit by which the receiving section 82 is followed and (ii) a power supply to a backlight. An antenna which can attain this driving capacity is exemplified as "test antenna" and is explained in the following descriptions.

A relationship between an electric conductivity of the test antenna and a voltage (of 20 V or more) obtained via the test antenna having such an electric conductivity is expressed in Table 2. (Hereinafter, this test antenna is referred to as "test antenna 1".) Table 2 shows the relationship between an electric conductivity (S/m) of the test antenna 1 and a voltage (V) generated.

An antenna as shown in Fig. 4 was used as the test antenna 1. Fig. 4 illustrates the configuration of the test antenna 1. As illustrated in Fig. 4, the test antenna 1, made of the antenna wire extending around in a loop manner, is configured such that: the number of turns is two; a width (indicated by "a" in Fig. 4) of the antenna wire is 0.35 mm; a clearance (i.e., a wire clearance) (indicated by "b" of Fig. 4) between the adjacent antenna wires is 0.20 mm; a distance (i.e., a lateral width of one side of the antenna) (indicated by "c" in Fig. 4) from an inner side of an inner antenna wire to an outer side of an outer antenna wire is less than 1.00 mm; a longitudinal width (indicated by "d" of Fig. 4) of a quadrangle defined by the outer antenna wire is 48.5 mm; a lateral width (indicated by "e" in Fig. 4) of the quadrangle is 39.9 mm; a film thickness is 900 nm; a load impedance is approximately 1 kQ; a load capacity is approximately 40 pF; and a consumption current is 50 mA. Further, a signal/electric power carrier was set to 27 MHz, which is equivalent to approximately 8 times as high as a base band of the signal, (i) in light of: QQVGA which appears to have a resolution allowing minimum information of characters and/or video information to be displayed; 6-bit RGB; and a capability of transmitting an information volume corresponding to approximately 3.4 Mbps of a non-compressed signal which is transmitted at a ratio of 10 fps (10 frames per second) and (ii) based on the common knowledge as to cutoff of a separation filter for separating the signal from the electric power carrier. Specifically, the signal/ electric power carrier is set to 27 MHz, which is equivalent to approximately 8 times as higher as the base band of the signal. It is commonly known that: an impedance of the antenna increases as carrier frequency increases because the impedance of the antenna is an inductance; and in a case of using a carrier frequency equal to or higher than 27 MHz, an impedance on an electric power supplying side should be suppressed to be equal to or lower than a load impedance. In view of the common knowledge, in order to reduce a total impedance of an L + R antenna, it is necessary to further improve an electric conductivity of the antenna. It follows that the conditions of the test antenna described herein substantially indicate a minimum of critical design conditions.

**[Table 2]**

| Voltage (V) | Electric conductivity (S/m) |
|---|---|
| 20 | 4.00 × 10⁷ |
| 23.5 | 4.50 × 10⁷ |
| 24.5 | 4.75 × 10⁷ |
| 26.6 | 5.00 × 10⁷ |
| 28 | 5.50 × 10⁷ |
| 30 | 6.00 × 10⁷ |
| 35 | 7.00 × 10⁷ |

As is clear from Table 2, in order to obtain a voltage of 20 V or more, it is preferable that the electric conductivity of the material of which the antenna 81 is made is 4.00 × 10⁷ (S/m) or higher. Since the electric conductivity of the aluminum alloy wire is approximately 2.50 × 10⁷ (S/m) at most, it is preferable that the electric conductivity of the material of which the antenna 81 is made is set to be 160% or higher of the electric conductivity of the aluminum alloy wire.

Note that the design of the antenna can be modified in some degree. As such, it is possible to design an antenna having a size enough to be put into practical use, provided that a material of which the antenna 81 is made has an electric conductivity of 150% or higher of an electric conductivity of a material of which the electric wiring is made. Similarly, considering that the design of the antenna can be modified in some degree, it is possible to design an antenna having a size enough to be out into practical use, provided that a material of which the antenna 81 is made has an electric conductivity of 3.80 × 10⁷ (S/m) or higher. Note that a margin of each critical value is set assuming that a variation of approximately 5% higher or lower than each target value is made by design flexibility.

The electric conductivities shown in Table 1 were measured at room temperature. It is a matter of course that the electric conductivity increases as the temperature decreases, whereas the electric conductivity decreases as the temperature increases. Further, the electric conductivities shown in Fig. 1 were measured with regard to respective ideal ingots. Actually, there occurs a reduction in the electric conductivity similar to a case of a silicon thin film, because a crystallization condition of atoms varies depending on a method such as deposition or sputtering employed in a film forming process. Note that the reduction in the electric conductivity caused by the crystallization condition may not matter, since a step of making the crystallization closer to an ideal one by a treatment such as a thermal treatment is considered as being similar to a step of processing a silicon thin film.

In the above-mentioned example, the film thickness is set to 900 nm. The reason for this is as follows: It is possible even for a high-resistance material to reduce its actual resistance in a case where its cross-sectional area (film thickness) is increased. However, a thick laminated film layer having a thickness exceeding 1000 nm brings about a technical problem caused by at least a peel strength of the thin film. This causes a significant increase in possibility of exfoliation, and therefore it becomes necessary to secure a very long processing time in a step such as a depositing step, thereby ultimately reducing manufacturing throughput. In view of the circumstances, in consideration of stability and a technical feasibility, the present embodiment gives an example as to how a power supply voltage is transmitted in a case where the antenna is assumed to have a film thickness of 900 nm. Although this is a condition under which a lowest electric conductivity is obtained, it is possible to realize a thin film thickness with use of a material having a high electric conductivity, thereby further improving industrial convenience.

An electromotive force of the antenna varies depending on a "length" by which the antenna wire comes across a magnetic flux generated from the transmitting coil. In view of this, in the above example, a liquid crystal display device of 2-inch class is assumed which is substantially a smallest one of screen sizes among current products for mobile phones. Since increasing the size does not raise a technical difficulty level, the example will be also applicable to a liquid crystal display device of a class larger than the 2-inch class if the example is effective for the liquid crystal display device of 2-inch class. It is often necessary to reduce the width of the frame of the 2-inch class to approximately 1 mm to 2 mm so that a product is mounted.

Next, the following describes a case of using a test antenna (test antenna 2) which is larger than the test antenna 1 in size. The test antenna 2 is different from the test antenna 1 in that the antenna wire has a width of approximately 0.70 mm, a clearance (i.e., the wire clearance) between the adjacent antenna wires which extend around is 0.50 mm, and a lateral width of one side of the antenna is 2.00 mm. A result of a simulation showed that the test antenna 2 having an electric conductivity of 4.00 × 10⁷ (S/m) caused a voltage of approximately 25 V to be generated. This is not a great improvement in the ability, as compared with 20 V caused by the test antenna 1. Other simulations, in which other test antennas 2 have respective electric conductivities, demonstrated that there is no significant difference between the voltage (see Table 2) caused by the test antenna 1 and respective of voltages caused by the respective other test antennas 2.

On the other hand, as shown in Table 2, the higher the electric conductivity of the material of which the antenna 81 is made (e.g., in case of the electric conductivity of 6.00 × 10⁷ (S/m)), the greater a voltage to be obtained (30 (V) to 35 (V)). As is clear from this, the voltage generation is affected more by the electric conductivity of the material of which the antenna is made than by the size of the antenna does. In view of this, making the antenna from a material having a high electric conductivity is extremely effective for addressing a problem of securing of electric power, a problem of downsizing, and a problem of heat generation.

In a case where the test antenna 1 or 2 is actually used as the antenna 81, the test antenna 1 or 2 is not limited to the foregoing configuration. These test antennas can be given a modification(s), for example, the number of turns formed by the antenna (may exceed 2), the wire width, the wire clearance, and/or the film thickness can be changed, provided that the modification(s) does not significantly impair the product value of the LCD module 150.

Further, silver or a silver alloy is most suitable for the material of which the antenna is made (see Table 1), since each of silver and a silver alloy has a high electric conductivity. Alternatively, copper or a copper alloy, which has a relatively high electric conductivity, can be used. Note however that use of copper or a copper alloy causes a problem of requiring a measure against environmental pollution, and therefore may increase cost in total, due to a manufacturing cost or a disposal/collection cost. Although use of gold or a gold alloy increases a material cost, it provides advantages of at least an improvement in chemical stability and an improvement in ease of processing. Further, generally, it is possible to further increase an electric conductivity of a metal material so as to be close to an ideal one by annealing the metal material. Here, the inventors have found it necessary that the antenna wire has a width of 2 mm or more and the number of the turns is four, in a case where a performance, equivalent to that of the test antenna 1 which (i) is made of a material (shown in Table 2) having an electric conductivity of 7.00 × 10⁷ (S/m) and (ii) causes a voltage of 35 V to be generated, is realized with use of an aluminum alloy wire having an electric conductivity of approximately 1.50 × 10⁷ (S/m) and a thickness of 900 nm which is the same as that of the test antenna 1.

### (Configuration of Substrate)

Next, the configuration of the substrate will be described.

Fig. 5 is a cross-section view of the active matrix substrate, and illustrates one example of a cross section of a part where the antenna 81 (antenna 10) is provided.

As illustrated in Fig. 5, the active matrix substrate includes an insulating substrate 1 which is an undermost layer. On the insulating substrate 1, a base coat film 2, a gate insulating film 3, a lower intermediate layer 4, an upper intermediate layer 5, an underpass layer 6 (an example of the electric wiring), a protective film 7, an interlayer insulating film 8, and a transparent conductive film (ITO (Indium Tin Oxide) film) 9 are formed in this order.

The transparent conductive film 9 has a part (an outermost peripheral part of the active matrix substrate) where the antenna 10 is formed. The antenna 10 is connected with the underpass layer 6 in a contact hole 11, via the transparent conductive film 9. Further, the transparent conductive film 9 has a part in which the antenna 10 is not formed and which is connected with the underpass layer 6 in a contact hole 12, which part serves as a terminal to be connected with an external circuit or serves as means for being connected with (i) an element or a device each of which is not the antenna or (ii) a circuit.

The underpass layer 6 is formed in a pattern (the parts indicated by "A" in Fig. 1) by which an end of an outer antenna wire of the antenna 10, formed so as to extend in loops, is pulled into an inner antenna wire side on which the receiving section 82 and the display section 85 are formed. Because of this, the underpass layer 6 has a part where the underpass layer 6 intersects with the antenna 10. In the present embodiment, the underpass layer 6 is made of the same material and in the same layer as those of the source electrodes of TFTs in the display section 85.

It should be noted that the antenna 10 is formed on the transparent conductive film 9. This allows a process for forming the antenna 10 to be carried out after completion of a process for forming the active matrix substrate. Therefore, it is not necessary to change the order of existing processes. Further, since the antenna 10 is formed on the transparent conductive film 9, the interlayer insulating film 8 and the transparent conductive film 9 are sandwiched between the part of the underpass layer 6 and the antenna 10 which intersect with each other.

Note that an interlayer insulating film 8 included in a generally-used active matrix substrate is formed to have a thickness of approximately 2500 nm. This secures a distance between the underpass layer 6 and the antenna 10. Such a distance allows a reduction in parasitic capacitance generated between the underpass layer 6 and the antenna 10. In other words, the antenna 10 is away from a layer in which the circuit is mounted, so that the adverse effect of such a parasitic capacitance can be reduced. This makes it possible to maintain a performance of the antenna 10 which is designed for high frequency.

Further, according to the present embodiment, the antenna 10, which has a lower resistance than the underpass 6, is formed such that the part of the antenna 10 where the underpass layer 6 and the antenna 10 intersect with each other has a width smaller than that of other parts of the antenna 10 (see the parts surrounded by the broken lines in Fig. 6). This allows a reduction in parasitic capacitance generated between the underpass layer 6 and the part of the antenna 10, while preventing the part from becoming a significant bottleneck resistance part.

In a case where (i) the antenna 10 is made of a silver alloy and (ii) the antenna 10 is formed on the interlayer insulating film 8 made of a material such as acrylic resin or polyimide, a problem such as peel-off is most likely to occur. A reason for this is that a resin like the acrylic resin, of which the interlayer insulating film 8 is made, has very bad adhesion with respect to silver. In view of this, in the present embodiment, the antenna 10 is formed on the transparent conductive film 9 which is provided on the interlayer insulating film 8. This can avoid the above-described problem of bad adhesion, instead of taking any special measures.

### (Method for Manufacturing Active Matrix Substrate)

Next, a method for manufacturing the active matrix substrate will be described. Fig. 7 shows a process of the manufacturing method.

### (Step 1)

Firstly, a glass substrate which has a thickness of approximately 300,000 nm to 700,000 nm and which has been subjected to washing is prepared as an insulating substrate 1 (see Fig. 7 (a)).

### (Step 2)

Next, as shown in Fig. 7 (b), a base coat film (tetraethylorthosilicate; TEOS) 2 of approximately 100 nm, a gate insulating film (TEOS) 3 of approximately 100 nm, a lower intermediate layer (silicon nitride, SiNx) 4 of several hundred nm, and an upper intermediate layer (TEOS) 5 of several hundred nm are consecutively deposited in this order by plasma CVD (chemical vapor deposition). Note that, in this step, a transistor or the like is additionally formed in the layers by providing gate wiring, and carrying out step processes such as deposition of a silicon film serving as a channel, crystallization, thermal activation, patterning by photolithography, and impurity doping. However, the explanations thereof are omitted here because they are not directly related to the steps of manufacturing the antenna.

### (Step 3)

Then, an underpass layer (Ti - Al - Ti) 6 of several hundred nm is deposited by sputtering. After the deposition, the underpass layer 6 is processed by photolithography to have a predetermined pattern (see Fig. 7 (c)). Note that Step 3 is carried out at the time of manufacturing of source electrodes of TFTs.

### (Step 4)

Thereafter, a protective film (SiNx) 7 of several hundred nm is deposited by plasma CVD (see Fig. 7 (d)).

### (Step 5)

Subsequently, in order to form contact holes 11 and 12, the protective film 7 is subjected to etching by photolithography so as to have a predetermined pattern (see Fig. 7 (e)).

### (Step 6)

Next, an interlayer insulating film 8 of approximately 2500 nm is deposited. As shown in Fig. 7 (f), in the deposition, the interlayer insulating film 8 is formed so as to have a pattern in which the shapes of the respective contact holes 11 and 12 are maintained.

### (Step 7)

Thereafter, a transparent conductive film (ITO) 9 of approximately 100 nm is deposited by sputtering. After the deposition, the transparent conductive film 9 is processed by photolithography so as to have a predetermined pattern (see Fig. 7 (g)).

### (Step 8)

Then, an antenna (silver alloy) 10 of several hundred nm is deposited by CVD. The thickness of the antenna 10 to be formed is as described above. After the deposition, the antenna 10 is processed by photolithography to have a predetermined pattern (see Fig. 7 (h)). This causes a part of the antenna 10 where the antenna 10 intersects with the underpass layer 6 to have a smaller width than that of the other parts of the antenna 10. Through the above-described steps, the active matrix substrate can be manufactured.

The configuration thus described in the present embodiment is just one example, and therefore can be modified in many ways. For example, in the display system 100, the video signal 42 and the control/timing signal 43 can be transmitted not only via electromagnetic waves as described above but also via light, for example. In the case of transmitting the signals via light, the transmitting function of the driving device 50 can be achieved by a generally-used LED (Light Emitting Diode) and a driving circuit for the LED, and the receiving function of the wireless display device 90 can be achieved by a generally-used photodiode. Further, the display system 100 may be configured so that not all of the video signal 42, the control/timing signal 43, and the electric power 44 are transmitted but only one or two of them is/are transmitted.

Note that an antenna of the present invention is applicable to the transmitting antenna 46. Note also that an antenna of the present invention is applicable to any devices, provided that the antenna is applied to a usage in which electric power is transmitted at least between devices completely in a non-contact manner.

The LCD module 150 shown in Fig. 3 causes a reduction in consideration of a designer of the handset with respect to positioning of an FPC (Flexible Printed Circuit), thereby causing an increase in flexibility in designing. Further, the LCD module 150 provides a new method/mode of use. For example, according to such a new method/mode of use, a user can replace the LCD module 150 with another LCD module which is purchased by the user and which is packaged in a plastic pack having a user's favorite picture and/or pattern. Thus, an entirely new style of distribution/sales of an LCD module is possible.

Further, the antenna device of the present embodiment can be configured such that: the material of which the electric wiring is made is aluminum or an aluminum alloy including aluminum as a main component.

Since a technique for forming a thin film of an aluminum alloy has been widely spread, the electric wiring can be easily formed by an existing process.

Furthermore, the antenna device of the present embodiment can be configured such that: the material of which the antenna is made has an electric conductivity of 3.80 × 10⁷ S/m or higher.

With this configuration, it is thus possible to design an antenna having a size enough for a practical use.

Moreover, the antenna device of the present embodiment can be configured such that: the material of which the antenna is made has an electric conductivity of 150% or more of an electric conductivity of the material of which the electric wiring is made.

With this configuration, it is thus possible to design an antenna having a size enough for a practical use.

Further, the antenna device of the present embodiment can be configured such that: the material of which the antenna is made is silver, a silver alloy including silver as a main component, copper, a copper alloy including copper as a main component, gold, or a gold alloy including gold as a main component.

With this configuration, it is possible to downsize the antenna sufficiently, since the above-mentioned metals have a relatively high electric conductivity.

Furthermore, the display device substrate of the present embodiment can be configured such that: the antenna is formed so as to extend in a loop-shape.

With this configuration, it is possible to achieve a so-called loop antenna.

Moreover, the display device substrate of the present embodiment can be configured such that: the antenna is formed in two or more turns.

This configuration allows the antenna to easily generate a great voltage.

Further, the display device substrate of the present embodiment may be configured such that: the region outside the display region is a frame region of the display device substrate.

With this configuration, it is possible to reduce the size of the antenna. Therefore, for example, a small portable device can easily accommodate the antenna in its frame region having a width of merely approximately 1 (mm) to 2 (mm).

Furthermore, the display device substrate of the present embodiment can be configured such that: thin film transistors, pixel electrodes, scanning signal lines, and data signal lines are formed on the substrate.

With this configuration, since the active matrix substrate is formed through a thin film forming process, it is possible to carry out all processes through a thin film process.

Moreover, the display device substrate of the present embodiment may further include: an interlayer insulating film provided above the thin film transistor but between the substrate and the pixel electrode, the antenna being provided above the interlayer insulating film.

Further, a method for manufacturing the display device substrate of the present embodiment may be: the method for forming the display device substrate, wherein thin film transistors, pixel electrodes, scanning signal lines, and data signal lines are formed on the substrate, said method including the steps of: forming an interlayer insulating film above the thin film transistor but between the substrate and the pixel electrode; and forming the antenna above the interlayer insulating film.

With these configuration and method, it is possible to carry out a process for forming the antenna after completion of a process for forming the active matrix substrate. Therefore, it is not necessary to change an order of existing processes. Further, it is possible to reduce a stray capacitance generated between (i) the antenna and (ii) a driver circuit for driving pixels, its wiring, and/or the like.

Further, the display device substrate of the present embodiment can be configured such that: the interlayer insulating film is made of a resin having a low permittivity.

With this configuration, since the interlayer insulating film is made of the resin having a low permittivity, it is possible to further reduce a stray capacitance generated between (i) the antenna and (ii) a driving circuit for driving pixels, its electric wiring, and/or the like.

Further, the display device substrate of the present embodiment can be configured such that: the antenna and the electric wiring intersect with each other; and at least a part of the electric wiring where the electric wiring intersects with the antenna is provided in a layer between the interlayer insulating film and the substrate.

Furthermore, a method for manufacturing the display device substrate of the present embodiment can further include: causing the antenna and the electric wiring to intersect with each other so that at least a part of the electric wiring where the electric wiring intersects with the antenna is formed in a layer between the interlayer insulating film and the substrate.

With these configuration and method, since the antenna and the electric wiring intersect with each other via the interlayer insulating film, which has a relatively large thickness, it is possible to reduce a parasitic capacitance generated in a part where the antenna and the electric wiring intersect with each other.

Further, the display device substrate of the present embodiment can be configured such that: the antenna and the electric wiring intersect with each other; and a part of the antenna where the antenna intersects with the electric wiring has a smaller width than that of a part of the antenna where the antenna does not intersect with the electric wiring.

Furthermore, the method for manufacturing the display device substrate of the present embodiment may such that: the antenna and the electric wiring intersect with each other, and a part of the antenna where the antenna intersects with the electric wiring has a smaller width than that of a part of the antenna where the antenna does not intersect with the electric wiring.

According to these configuration and method, the part of the electric wiring where the antenna and the electric wiring intersect with each other has a smaller width. Therefore, it is possible to reduce a parasitic capacitance generated in the part where the antenna and the electric wiring intersect with each other, without reducing a resistance in a part where the antenna and the electric wiring does not intersect with each other.

Moreover, the display device substrate of the present embodiment can be configured such that: a material of which the antenna is made is a silver alloy including silver as a main component; and the antenna is provided in a layer which is above an indium tin oxide (ITO) film provided above the interlayer insulating film.

Further, the method for manufacturing the display device substrate of the present embodiment can be such that: a material of which the antenna is made is a silver alloy including silver as a main component; and the antenna is provided in a layer which is above an ITO film provided above the interlayer insulating film.

With these configuration and method, a silver alloy film is stacked on the interlayer insulating film via the ITO film. This increases the adhesion therebetween, as compared with a case where the silver alloy film is directly stacked on the interlayer insulating film.

Further, the display device substrate of the present embodiment can be configured such that: the display circuit receives one of or both of a signal and electric power from an external device by wireless, and the electric power is received, via the antenna, by the display circuit with use of electromagnetic induction or resonance.

With this configuration, transmission/reception of a signal required for carrying out a display and electric power supply can be achieved by wireless.

### Industrial Applicability

An antenna according to the present invention, made of a material having a high electric conductivity, provides an excellent effect helpful in dealing with a problem related to securing of electric power, a problem related to downsizing, and a problem of heat generation, and is suitably used in any devices at least as long as the antenna is used for the purpose of transmitting electric power between devices completely in a non-contact manner.

## Claims

1. A display device substrate comprising
a substrate (1);
an antenna (81) device,
the antenna device comprising:
an antenna (81) for inputting and outputting electromagnetic energy; and
electric wiring (6) electrically connecting the antenna (81) with an electric circuit (85),
the antenna (81) and the electric wiring (6) being monolithically formed on the substrate (1) through a thin film process, and
a material of which the antenna (81) is made having a higher electric conductivity than that of a material of which the electric wiring (6) is made
**characterized in that** the display device substrate further comprises:
a display circuit, which drives a plurality of pixels, being formed on the substrate (1) as the electric circuit (85),
the antenna (81) being provided in a region outside a display region (73) where the plurality of pixels are provided.

2. The display device substrate as set forth in claim 1, wherein:
the material of which the electric wiring (6) is made is aluminum or an aluminum alloy including aluminum as a main component.

3. The display device substrate as set forth in claim 1 or 2, wherein:
the material of which the antenna (81) is made has an electric conductivity of 3.80 * 107 S/m or higher.

4. The display device substrate as set forth in any one of claims 1 through 3, wherein:
the material of which the antenna (81) is made has an electric conductivity of 150% or more of an electric conductivity of the material of which the electric wiring (6) is made.

5. The display device substrate as set forth in any one of claims 1 through 4, where-in:
the material of which the antenna (81) is made is silver, a silver alloy including silver as a main component, copper, a copper alloy including copper as a main component, gold, or a gold alloy including gold as a main component.

6. The display device substrate as set forth in any one of claims 1 through5, wherein the antenna (81) is formed so as to extend in a loop-shape.

7. The display device substrate as set forth in any one of claims 1 through6. wherein the antenna (81) is formed in two or more turns.

8. The display device substrate as set forth in any one of claims 1 through 7, wherein the region outside the display region (73) is a frame region (B) of the display device substrate.

9. The display device substrate as set forth in any one of claims 1 through 8, wherein thin film transistors, pixel electrodes, scanning signal lines (G), and data signal lines (S) are formed on the substrate (1).

10. The display device substrate as set forth in claim 9, further comprising:
an interlayer insulating film (8) provided above the thin film transistor but between the substrate (1) and the pixel electrode,
the antenna (81) being provided above the interlayer insulating film (8).

11. The display device substrate as set forth in claim 10, wherein the interlayer insulating film (8) is made of a resin having a low permittivity.

12. The display device substrate as set forth in claim 10 or 11, wherein:
the antenna (81) and the electric wiring (6) intersect with each other; and
at least a part of the electric wiring (6) where the electric wiring (6) intersects with the antenna (81) is provided in a layer between the interlayer insulating film (8) and the substrate (1).

13. The display device substrate as set forth in claim 10. or 12, wherein:
the antenna (81) and the electric wiring (6) intersect with each other; and
a part of the antenna (81) where the antenna (81) intersects with the electric wiring (6) has a smaller width than that of a part of the antenna (81) where the antenna (81) does not intersect with the electric wiring (6).

14. The display device substrate as set forth in any one of claims 10 through 13. wherein:
a material of which the antenna (81) is made is a silver alloy including silver as a main component; and
the antenna (81) is provided in a layer which is above an indium tin oxide film provided above the interlayer insulating film (8).

15. The display device substrate as set forth in any one of claims 1 through 14, wherein:
the display circuit (85) receives one of or both of a signal and electric power from an external device by wireless, and the electric power is received, via the antenna (81), by the display circuit(85) with use of electromagnetic induction or resonance.

16. A liquid crystal display unit, comprising a display device substrate as set forth in any one of claims 1 through 15.
said liquid crystal display unit carrying out a display by applying a voltage to liquid crystal.

17. A display system, comprising:
a transmitting device (50) for transmitting, by wireless, one of or both of a signal and electric power each of which is used by a display circuit (85) in a receiving device to carry out a target display; and
the receiving device including a display device substrate as set forth in claim 15.

18. A method for manufacturing a display device substrate which includes an antenna device, the antenna device including:
a substrate (1);
an antenna (81) for inputting and outputting electromagnetic energy; and
electric wiring (6) electrically connecting the antenna (81) with an electric circuit (85);
the antenna (81) being made of a material having a higher electric conductivity than that of a material of which the electric wiring (6) is made,
**characterized in that**
a display circuit which drives a plurality of pixels is formed on the substrate (1) as the electric circuit (85); and
the antenna (81) is provided in a region outside a display region (73) where the plurality of pixels are provided,
the antenna device being manufactured by a method comprising the step of:
monolithically forming the antenna (81) and the electric wiring (6) on the substrate (1) through a thin film process.

19. The method as set forth in claim 18, wherein thin film transistors, pixel electrodes, scanning signal lines (G), and data signal lines (S) are formed on the substrate (1).
said method comprising the steps of:
forming an interlayer insulating film (8) above the thin film transistor but between the substrate (1) and the pixel electrode; and
forming the antenna (81) above the interlayer insulating film (8).

20. The method as set forth in claim 19, further comprising the step of:
causing the antenna (81) and the electric wiring (6) to intersect with each other so that at least a part of the electric wiring (6) where the electric wiring (6) intersects with the antenna (81) is formed in a layer between the interlayer insulating film (8) and the substrate (1).

21. The method as set forth in claim 19 or 20, wherein:
the antenna (81) and the electric wiring (6) intersect with each other, and a part of the antenna (81) where the antenna (81) intersects with the electric wiring (6) has a smaller width than that of a part of the antenna (81) where the antenna (81) does not intersect with the electric wiring (6).

22. The method as set forth in any one of claims 19 through 21, wherein:
a material of which the antenna (81) is made is a silver alloy including silver as a main component; and
the antenna (81) is provided in a layer which is above an indium tin oxide film provided above the interlayer insulating film (8).

## Patentansprüche

1. Anzeigevorrichtungssubstrat, das enthält:
ein Substrat (1);
eine Antennenvorrichtung (81),
wobei die Antennenvorrichtung enthält:
eine Antenne (81) zum Eingeben und Ausgeben von elektromagnetischer Energie; und
elektrische Leitungen (6), die die Antenne (81) mit einer elektrischen Schaltung (85) elektrisch verbinden;
wobei die Antenne (81) und die elektrischen Leitungen (6) auf dem Substrat (1) durch ein Dünnschichtverfahren monolithisch gebildet sind und
ein Material, aus dem die Antenne (81) hergestellt ist, eine größere elektrische Leitfähigkeit als ein Material, aus dem die elektrischen Leitungen (6) hergestellt sind, besitzt,
**dadurch gekennzeichnet, dass** das Anzeigevorrichtungssubstrat ferner enthält:
eine Anzeigeschaltung, die mehrere Pixel ansteuert, die auf dem Substrat (1) als die elektrische Schaltung (85) gebildet ist,
wobei sich die Antenne (81) in einem Bereich außerhalb eines Anzeigebereichs (73), in dem sich die mehreren Pixel befinden, befindet.

2. Anzeigevorrichtungssubstrat nach Anspruch 1, wobei:
das Material, aus dem die elektrischen Leitungen (6) hergestellt sind, Aluminium oder eine Aluminiumlegierung, die als Hauptkomponente Aluminium enthält, ist.

3. Anzeigevorrichtungssubstrat nach Anspruch 1 oder 2, wobei:
das Material, aus dem die Antenne (81) hergestellt ist, eine elektrische Leitfähigkeit von 3,80 × 107 S/m oder mehr besitzt.

4. Anzeigevorrichtungssubstrat nach einem der Ansprüche 1 bis 3, wobei:
das Material, aus dem die Antenne (81) hergestellt ist, eine elektrische Leitfähigkeit von 150 % oder mehr einer elektrischen Leitfähigkeit des Materials, aus dem die elektrischen Leitungen (6) hergestellt sind, besitzt.

5. Anzeigevorrichtungssubstrat nach einem der Ansprüche 1 bis 4, wobei:
das Material, aus dem die Antenne (81) hergestellt ist, Silber, eine Silberlegierung, die als Hauptkomponente Silber enthält, Kupfer, eine Kupferlegierung, die als Hauptkomponente Kupfer enthält, Gold, oder eine Goldlegierung, die als Hauptkomponente Gold enthält, ist.

6. Anzeigevorrichtungssubstrat nach einem der Ansprüche 1 bis 5, wobei die Antenne (81) so geformt ist, dass sie sich in einer Schleifenform erstreckt.

7. Anzeigevorrichtungssubstrat nach einem der Ansprüche 1 bis 6, wobei die Antenne (81) in zwei oder mehr Windungen geformt ist.

8. Anzeigevorrichtungssubstrat nach einem der Ansprüche 1 bis 7, wobei der Bereich außerhalb des Anzeigebereichs (73) ein Rahmenbereich (B) des Anzeigevorrichtungssubstrats ist.

9. Anzeigevorrichtungssubstrat nach einem der Ansprüche 1 bis 8, wobei auf dem Substrat (1) Dünnschichttransistoren, Pixelelektroden, Abtastsignalleitungen (G) und Datensignalleitungen (S) gebildet sind.

10. Anzeigevorrichtungssubstrat nach Anspruch 9, das ferner enthält:
eine Zwischenschichtisolierschicht (8), die sich über dem Dünnschichttransistor, aber zwischen dem Substrat (1) und der Pixelelektrode befindet,
wobei sich die Antenne (81) über der Zwischenschichtisolierschicht (8) befindet.

11. Anzeigevorrichtungssubstrat nach Anspruch 10, wobei die Zwischenschichtisolierschicht (8) aus einem Harz mit einer geringen Dielektrizitätskonstante hergestellt ist.

12. Anzeigevorrichtungssubstrat nach Anspruch 10 oder 11, wobei:
die Antenne (81) und die elektrischen Leitungen (6) einander kreuzen; und
sich mindestens ein Teil der elektrischen Leitungen (6), wo die elektrischen Leitungen (6) die Antenne (81) kreuzen, in einer Schicht zwischen der Zwischenschichtisolierschicht (8) und dem Substrat befindet.

13. Anzeigevorrichtungssubstrat nach Anspruch 10, 11 oder 12, wobei:
die Antenne (81) und die elektrischen Leitungen (6) einander kreuzen; und
ein Teil der Antenne (81), wo die Antenne (81) die elektrischen Leitungen (6) kreuzt, eine kleinere Breite als ein Teil der Antenne (81), wo die Antenne (81) die elektrischen Leitungen (6) nicht kreuzt, hat.

14. Anzeigevorrichtungssubstrat nach einem der Ansprüche 10 bis 13, wobei:
ein Material, aus dem die Antenne (81) hergestellt ist, eine Silberlegierung, die als Hauptkomponente Silber enthält, ist; und
die Antenne (81) sich in einer Schicht befindet, die sich über einer über der Zwischenschichtisolierschicht (8) sich befindenden Indiumzinnoxidschicht befindet.

15. Anzeigevorrichtungssubstrat nach Anspruch 1 bis 14, wobei:
die Anzeigeschaltung (85) ein Signal und/oder eine elektrische Leistung von einer externen Vorrichtung kabellos empfängt, und die elektrische Leistung über die Antenne (81) durch die Anzeigeschaltung (85) unter Verwendung von elektromagnetischer Induktion oder Resonanz empfangen wird.

16. Flüssigkristallanzeigeeinheit, die ein Anzeigevorrichtungssubstrat nach einem der Ansprüche 1 bis 15 enthält,
wobei die Flüssigkristallanzeigeeinheit eine Anzeige durch Anlegen einer Spannung an den Flüssigkristall ausführt.

17. Anzeigesystem, das enthält:
eine Sendevorrichtung (50) zum kabellosen Senden, eines Signals und/oder von elektrischer Leistung, wovon jedes durch eine Anzeigeschaltung (85) in einer Empfangsvorrichtung zum Ausführen einer Zielanzeige verwendet wird; und
die Empfangsvorrichtung ein Anzeigevorrichtungssubstrat nach Anspruch 15 enthält.

18. Verfahren zum Herstellen eines Anzeigevorrichtungssubstrats, das eine Antennenvorrichtung enthält, wobei die Antennenvorrichtung enthält:
ein Substrat (1);
eine Antenne (81) zum Eingeben und Ausgeben von elektromagnetischer Energie; und
elektrische Leitungen (6), die die Antenne (81) elektrisch mit einer elektrischen Schaltung (85) verbinden;
wobei die Antenne (81) aus einem Material mit einer größeren elektrischen Leitfähigkeit als ein Material, aus dem die elektrischen Leitungen (6) hergestellt sind, hergestellt ist,
**dadurch gekennzeichnet, dass**
eine Anzeigeschaltung, die mehrere Pixel antreibt, auf dem Substrat (1) als die elektrische Schaltung (85) gebildet ist, und
die Antenne (81) sich in einem Bereich außerhalb eines Anzeigebereichs (73), in dem sich die mehreren Pixel befinden, befindet, wobei die Antennenvorrichtung durch ein Verfahren hergestellt wird, dass den Schritt enthält:
monolithisches Bilden der Antenne (81) und der elektrischen Leitungen (6) durch ein Dünnschichtverfahren auf dem Substrat.

19. Verfahren nach Anspruch 18, wobei Dünnschichttransistoren, Pixelelektroden, Abtastsignalleitungen (G) und Datensignalleitungen (S) auf dem Substrat (1) gebildet sind,
wobei das Verfahren die Schritte enthält:
Bilden einer Zwischenschichtisolierschicht (8) über dem Dünnschichttransistor, aber zwischen dem Substrat (1) und der Pixelelektrode; und
Bilden der Antenne (81) über der Zwischenschichtisolierschicht (8).

20. Verfahren nach Anspruch 19, das ferner die Schritte enthält:
Bewirken, dass die Antenne (81) und die elektrischen Leitungen (6) einander kreuzen, so dass mindestens ein Teil der elektrischen Schaltungen (6), wo die elektrischen Schaltungen (6) die Antenne (81) kreuzen, in einer Schicht zwischen der Zwischenschichtisolierschicht (8) und dem Substrat (1) gebildet ist.

21. Verfahren nach Anspruch 19 oder 20, wobei:
die Antenne (81) und die elektrischen Leitungen (6) einander kreuzen und ein Teil der Antenne (81), wo die Antenne (81) die elektrischen Leitungen (6) kreuzt, eine kleinere Breite als ein Teil der Antenne (81), wo die Antenne (81) die elektrischen Leitungen (6) nicht kreuzt, besitzt.

22. Verfahren nach einem der Ansprüche 19 bis 21, wobei:
ein Material, aus dem die Antenne (81) hergestellt ist, eine Silberlegierung, die als Hauptkomponente Silber enthält, ist; und
die Antenne (81) sich in einer Schicht, die sich über einer sich über der Zwischenschichtisolierschicht (8) befindenden Indiumzinnoxidschicht befindet, befindet.

## Revendications

1. Substrat de dispositif d'affichage comprenant
un substrat (1) ;
un dispositif d'antenne (81),
le dispositif d'antenne comprenant :
une antenne (81) pour l'entrée et la sortie d'énergie électromagnétique ; et
un câblage électrique (6) qui connecte électriquement l'antenne (81) et un circuit électrique (85),
l'antenne (81) et le câblage électrique (6) étant formés de manière monolithique sur le substrat (1) par l'intermédiaire d'un procédé de couche mince, et
un matériau à partir duquel l'antenne (81) est fabriquée présentant une conductivité électrique supérieure à celle d'un matériau à partir duquel le câblage électrique (6) est fabriqué,
**caractérisé en ce que** le substrat de dispositif d'affichage comprend en outre :
un circuit d'affichage, lequel attaque une pluralité de pixels, réalisé sur le substrat (1) sous la forme du circuit électrique (85),
l'antenne (81) étant disposée sur une région à l'extérieur d'une région d'affichage (73) contenant la pluralité de pixels.

2. Substrat de dispositif d'affichage conformément à la revendication 1, dans lequel :
le matériau à partir duquel le câblage électrique (6) est fabriqué est de l'aluminium ou un alliage d'aluminium comprenant de l'aluminium comme constituant principal.

3. Substrat de dispositif d'affichage conformément à la revendication 1 ou 2, dans lequel :
le matériau à partir duquel l'antenne (81) est fabriquée présente une conductivité électrique de 3,80 · 107 S/m ou plus.

4. Substrat de dispositif d'affichage conformément à l'une quelconque des revendications 1 à 3, dans lequel :
le matériau à partir duquel l'antenne (81) est fabriquée présente une conductivité électrique de 150% ou plus d'une conductivité électrique du matériau à partir duquel le câblage électrique (6) est fabriqué.

5. Substrat de dispositif d'affichage conformément à l'une quelconque des revendications 1 à 4, dans lequel
le matériau à partir duquel l'antenne (81) est fabriquée est de l'argent, un alliage d'argent comprenant de l'argent comme constituant principal, du cuivre, un alliage de cuivre comprenant du cuivre comme constituant principal, de l'or, ou un alliage d'or comprenant de l'or comme constituant principal.

6. Substrat de dispositif d'affichage conformément à l'une quelconque des revendications 1 à 5, dans lequel l'antenne (81) est formée de manière à s'étendre selon une forme en boucle.

7. Substrat de dispositif d'affichage conformément à l'une quelconque des revendications 1 à 6, dans lequel l'antenne (81) est réalisée sous la forme de deux spires ou plus.

8. Substrat de dispositif d'affichage conformément à l'une quelconque des revendications 1 à 7, dans lequel la région à l'extérieur de la région d'affichage (73) est une région de cadre (B) du substrat de dispositif d'affichage.

9. Substrat de dispositif d'affichage conformément à l'une quelconque des revendications 1 à 8, dans lequel les transistors à couches minces, les électrodes de pixel, les lignes de signal de balayage (G) et les lignes de signal de données (S) sont formés sur le substrat (1).

10. Substrat de dispositif d'affichage conformément à la revendication 9 comprenant en outre :
une couche isolante intermédiaire (8) disposée au-dessus du transistor à couches minces mais entre le substrat (1) et l'électrode de pixel,
l'antenne (81) étant disposée au-dessus de la couche isolante intermédiaire (8).

11. Substrat de dispositif d'affichage conformément à la revendication 10, dans lequel la couche isolante intermédiaire (8) est constituée de résine présentant une faible permittivité.

12. Substrat de dispositif d'affichage conformément à la revendication 10 ou 11, dans lequel :
l'antenne (81) et le câblage électrique (6) se croisent mutuellement ; et
au moins une partie du câblage électrique (6) au niveau duquel le câblage électrique (6) et l'antenne (81) se croisent est disposée dans une couche située entre la couche isolante intermédiaire (8) et le substrat (1).

13. Substrat de dispositif d'affichage conformément à la revendication 10, 11 ou 12, dans lequel :
l'antenne (81) et le câblage électrique (6) se croisent mutuellement ; et
une partie de l'antenne (81) au niveau de laquelle l'antenne (81) et le câblage électrique (6) se croisent présente une largeur plus petite que celle d'une partie de l'antenne (81) au niveau de laquelle l'antenne (81) et le câblage électrique (6) ne se croisent pas.

14. Substrat de dispositif d'affichage conformément à l'une quelconque des revendications 10 à 13, dans lequel :
un matériau à partir duquel l'antenne (81) est fabriquée est un alliage d'argent comprenant de l'argent comme constituant principal ; et
l'antenne (81) est disposée dans une couche qui est située au-dessus d'une couche d'oxyde d'étain et d'indium disposée au-dessus de la couche isolante intermédiaire (8).

15. Substrat de dispositif d'affichage conformément à l'une quelconque des revendications 1 à 14, dans lequel :
le circuit d'affichage (85) reçoit un signal et/ou de l'énergie électrique d'un dispositif externe de manière sans fil, et l'énergie électrique est reçue, par l'intermédiaire de l'antenne (81), par le circuit d'affichage (85) à l'aide d'induction ou de résonance électromagnétique.

16. Unité d'affichage à cristaux liquides comprenant un substrat de dispositif d'affichage conformément à l'une quelconque des revendications 1 à 15,
ladite unité d'affichage à cristaux liquides effectuant un affichage par l'application d'une tension à du cristal liquide.

17. Système d'affichage comprenant :
un dispositif émetteur (50) pour émettre, de manière sans fil, un signal et/ou une énergie électrique qui sont chacun utilisés par un circuit d'affichage (85) dans un dispositif récepteur afin d'effectuer un affichage cible ; et
le dispositif récepteur comprenant un substrat de dispositif d'affichage conformément à la revendication 15.

18. Procédé de fabrication d'un substrat de dispositif d'affichage qui comprend un dispositif d'antenne, ledit dispositif comprenant :
un substrat (1) ;
une antenne (81) pour l'entrée et la sortie d'énergie électromagnétique ; et
un câblage électrique (6) qui connecte électriquement l'antenne (81) et un circuit électrique (85) ;
l'antenne (81) étant constituée d'un matériau présentant une conductivité électrique supérieure à celle d'un matériau à partir duquel le câblage électrique (6) est fabriqué,
**caractérisé en ce que**
un circuit d'affichage qui attaque une pluralité de pixels est réalisé sur le substrat (1) sous la forme du circuit électrique (85) ; et
l'antenne (81) est disposée dans une région à l'extérieur d'une région d'affichage (73) contenant la pluralité de pixels,
le dispositif d'antenne étant fabriqué par un procédé comprenant l'étape :
de formation de l'antenne (81) et du câblage électrique (6) de manière monolithique sur le substrat (1) par l'intermédiaire d'un procédé de film mince.

19. Procédé conformément à la revendication 18, dans lequel les transistors à couches minces, les électrodes de pixel, les lignes de signal de balayage (G), et les lignes de signal de données (S) sont formés sur le substrat (1),
ledit procédé comprenant les étapes :
de formation d'une couche isolante intermédiaire (8) au-dessus du transistor à couches minces mais entre le substrat (1) et l'électrode de pixel ; et
de formation de l'antenne (81) au-dessus de la couche isolante intermédiaire (8).

20. Procédé conformément à la revendication 19 comprenant en outre l'étape :
de provocation de croisement mutuel de l'antenne (81) et du câblage électrique (6) de sorte qu'au moins une partie du câblage électrique (6) au niveau de laquelle le câblage électrique (6) et l'antenne (81) se croisent est formée dans une couche comprise entre la couche isolante intermédiaire (8) et le substrat (1).

21. Procédé conformément à la revendication 19 ou 20 dans lequel :
l'antenne (81) et le câblage électrique (6) se croisent mutuellement, et une partie de l'antenne (81) au niveau de laquelle l'antenne (81) et le câblage électrique (6) se croisent présente une largeur plus petite que celle d'une partie de l'antenne (81) au niveau de laquelle l'antenne (81) et le câblage électrique (6) ne se croisent pas.

22. Procédé conformément à l'une quelconque des revendications 19 à 21, dans lequel :
un matériau à partir duquel l'antenne (81) est fabriquée est un alliage d'argent comprenant de l'argent comme constituant principal ; et
l'antenne (81) est dotée d'une couche qui est située au-dessus d'une couche d'oxyde d'étain et d'indium disposée au-dessus de la couche isolante intermédiaire (8).
